(19) Europäisches Patentamt / European Patent Office / Office européen des brevets

(11) **EP 3 152 787 B1**

(12) **FASCICULE DE BREVET EUROPEEN**

(45) Date de publication et mention de la délivrance du brevet:
**18.08.2021 Bulletin 2021/33**

(21) Numéro de dépôt: **15732840.2**

(22) Date de dépôt: **02.06.2015**

(51) Int Cl.:
**H01L 31/054** *(2014.01)*　　**H01L 31/055** *(2014.01)*

(86) Numéro de dépôt international:
**PCT/FR2015/051460**

(87) Numéro de publication internationale:
**WO 2015/185855 (10.12.2015 Gazette 2015/49)**

(54) **DISPOSITIF PHOTOVOLTAÏQUE ET PROCÉDÉ DE FABRICATION ASSOCIÉ**

PHOTOVOLTAISCHE VORRICHTUNG UND ZUGEHÖRIGES HERSTELLUNGSVERFAHREN

PHOTOVOLTAIC DEVICE AND ASSOCIATED MANUFACTURING PROCESS

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **05.06.2014 FR 1455122**

(43) Date de publication de la demande:
**12.04.2017 Bulletin 2017/15**

(73) Titulaires:
- **Electricité de France**
  **75008 Paris (FR)**
- **Centre National de la Recherche Scientifique (C.N.R.S.)**
  **75016 Paris (FR)**

(72) Inventeurs:
- **PAIRE, Myriam**
  **F-75017 Paris (FR)**
- **PROISE, Florian**
  **F-75014 Paris (FR)**
- **LINCOT, Daniel**
  **F-92160 Antony (FR)**
- **GUILLEMOLES, Jean-François**
  **F-75013 Paris (FR)**
- **PELOUARD, Jean-Luc**
  **F-75020 Paris (FR)**
- **JUTTEAU, Sébastien**
  **F-78160 Marly le Roi (FR)**

(74) Mandataire: **Plasseraud IP**
  **66, rue de la Chaussée d'Antin**
  **75440 Paris Cedex 09 (FR)**

(56) Documents cités:
WO-A1-2006/035698　　WO-A1-2013/183752
WO-A1-2014/038568　　US-A1- 2009 126 778
US-A1- 2011 011 449

## Description

La présente invention concerne un dispositif photovoltaïque. WO 2013/183752 traite de ce sujet.

Ce type de dispositif est largement répandu et a vocation à convertir de l'énergie solaire en énergie électrique.

Pour ce faire, ces dispositifs sont pourvus de cellules photovoltaïques prévues pour être illuminées par la lumière du soleil et pour convertir cette lumière en énergie électrique par effet photoélectrique.

Afin d'améliorer le rendement de ce type de dispositif, il est connu d'utiliser de la lumière concentrée, ce qui a aussi pour avantage de diminuer la consommation de matière première photovoltaïque. Pour ce faire, les cellules peuvent être couplées à un guide de lumière prévu pour recevoir les photons et pour favoriser leur guidage jusqu'à la surface des cellules photovoltaïques.

Dans certains de ces dispositifs, les cellules sont agencées sur un réflecteur configuré pour réfléchir les photons et permettre leur recapture par le guide d'onde. Le guide d'onde est alors disposé au contact de ce réflecteur.

Toutefois, il a été constaté que les dispositifs de ce type présentaient des inconvénients. En effet, les réflecteurs présentent un coefficient de réflexion non idéal, ce qui se traduit par des pertes à chaque réflexion. En outre, chaque réflecteur présente généralement des rugosités locales, par exemple du fait de la rugosité du support sur lequel il est déposé, du vieillissement du réflecteur ou d'imperfections de fabrication. Sous certaines conditions, notamment de dimensions des rugosités non-négligeables devant la longueur d'onde des photons, ces rugosités engendrent un phénomène local de diffusion de la lumière se traduisant par une variation non contrôlée de l'angle de réflexion des photons, et donc une diminution globale de l'effet de guidage fourni par le guide d'onde.

La présente invention vient améliorer la situation.

A cet effet, l'invention vise un dispositif photovoltaïque selon la revendication 1 comprenant :

- une pluralité de cellules photovoltaïques, distantes les unes des autres,
- un support recevant les cellules, le support étant un réflecteur et présentant une face réfléchissante, et
- un guide de lumière au contact desdites cellules et comportant un guide primaire ayant une face proximale par rapport aux cellules, la face proximale étant orientée vers les cellules et la face réfléchissante.

En particulier, le dispositif comporte, entre les cellules, des zones situées entre le support et le guide primaire et comprenant un matériau d'indice de réfraction inférieur à celui de la face proximale, le matériau étant au contact de ladite face proximale.

Dans une réalisation simple de mise en œuvre, ce matériau est simplement de l'air, un espacement étant alors prévu entre les cellules.

Selon un aspect particulier de l'invention, le guide primaire est un concentrateur fluorescent. Ceci permet notamment de maximiser l'effet de guidage du guide de lumière vers les cellules et d'améliorer l'efficacité du dispositif.

Selon un autre aspect de l'invention, le support et la face proximale du guide primaire sont espacés d'une distance comprise entre 1 $\mu$m et 20 $\mu$m. Ceci permet notamment de limiter les effets de non-linéarité de la lumière pouvant survenir, qui limiteraient les performances de réflexion.

Dans une mise en œuvre particulière de l'invention, la distance entre la face proximale du guide primaire et le support est sensiblement égale à un multiple supérieur ou égal à deux d'une longueur d'onde caractéristique correspondant à une longueur d'onde privilégiée d'émission du guide primaire. Ceci permet de limiter plus avant les effets de non-linéarité précités.

Selon un aspect particulier de l'invention, une ou plusieurs cellules sont agencées en saillie par rapport au support en direction du guide primaire, le guide primaire étant au contact desdites cellules et maintenu à l'écart du support au moins par lesdites cellules. Ainsi, les cellules contribuent elles-mêmes à former les zones comportant le matériau.

Dans un mode de réalisation, le guide de lumière comprend une pluralité de guides secondaires séparés les uns des autres par ledit matériau, chaque guide secondaire étant interposé entre la face proximale du guide primaire et une cellule photovoltaïque. Ces guides permettent notamment de choisir finement la géométrie du dispositif tout en améliorant l'effet de guidage du guide de lumière, en permettant un bon couplage optique entre la cellule et le guide primaire, et ce même si la surface des cellules est rugueuse.

Selon un autre aspect de l'invention, les guides secondaires maintiennent la face proximale du guide primaire à l'écart du support au moins dans lesdites zones.

Dans une réalisation particulière de l'invention, chaque guide secondaire présente une face disposée au contact de la surface de la cellule photovoltaïque correspondante et présentant des dimensions sensiblement égales aux dimensions de la surface de ladite cellule, ladite face d'un guide secondaire donné étant disposée sensiblement bord à bord en regard de la surface de la cellule photovoltaïque correspondante. Ceci permet d'améliorer l'exposition des cellules aux photons provenant du guide primaire.

Selon un autre aspect de l'invention, l'un au moins des guides secondaires se présente sous la forme d'un plot de forme générale cylindrique dont la base est de dimensions sensiblement égales à celles de la surface de la cellule photovoltaïque correspondante. Ceci a notamment pour effet d'améliorer le transfert des photons depuis le guide primaire vers les cellules.

Dans une réalisation particulière de l'invention, le ou chaque guide secondaire présente un indice de réfraction compris entre l'indice de réfraction du guide primaire et l'indice de réfraction de la surface de la cellule photovoltaïque correspondante. Ainsi, les transferts de photons jusqu'aux cellules sont encore améliorés, car les réflexions aux différentes interfaces entre le guide primaire, le guide secondaire et les cellules, sont minimisées.

Par ailleurs, l'invention concerne un procédé de fabrication d'un dispositif photovoltaïque selon la revendication 9 comprenant :

- une pluralité de cellules photovoltaïques, distantes les unes des autres,
- un support au niveau duquel les cellules sont agencées, et
- un guide de lumière au contact desdites cellules et comportant un guide primaire ayant une face proximale par rapport aux cellules, la face proximale étant orientée vers les cellules et le support.

En particulier :

- on agence les cellules photovoltaïques au niveau du support et
- on agence le guide de lumière au contact des cellules photovoltaïques en ménageant, entre les cellules photovoltaïques, des zones situées entre le guide primaire et le support et comprenant un matériau d'indice de réfraction inférieur à celui de la face proximale, ledit matériau étant agencé au contact de ladite face proximale.

Selon un aspect du procédé selon l'invention, on obtient un ou plusieurs guides secondaires transparents qu'on interpose chacun entre le guide primaire et une cellule photovoltaïque. Ceci permet notamment de contrôler de façon précise la géométrie du dispositif et de limiter les phénomènes de non-linéarité.

Dans un mode de réalisation particulier, chaque guide secondaire est formé par dépôt directement au contact de la cellule photovoltaïque correspondante. Ceci permet par exemple de faciliter la fabrication du dispositif et de simplifier la gestion des stocks afférents.

Selon un autre aspect de l'invention, on forme par dépôt, au niveau du support, tout ou partie des cellules photovoltaïques de telle sorte que les cellules photovoltaïques correspondantes soient en saillie par rapport au support, et on dispose le guide primaire au contact desdits cellules en saillie. De la même manière, ceci permet de limiter les contraintes de stockage des pièces requises pour la fabrication du dispositif. Par ailleurs, cela simplifie la fabrication du fait de la diminution du nombre d'étapes nécessaires.

L'invention sera mieux comprise à la lecture de la description détaillée qui va suivre, donnée uniquement à titre d'exemple et faite en référence aux Figures annexées, sur lesquelles :

- La Figure 1 est une illustration schématique d'un dispositif photovoltaïque selon l'invention ;
- La Figure 2 est une vue en coupe du dispositif de la Figure 1 ;
- La Figure 3 est une vue en coupe d'un dispositif selon une première variante de l'invention, et
- La Figure 4 est une vue en coupe d'un dispositif selon une deuxième variante de l'invention.

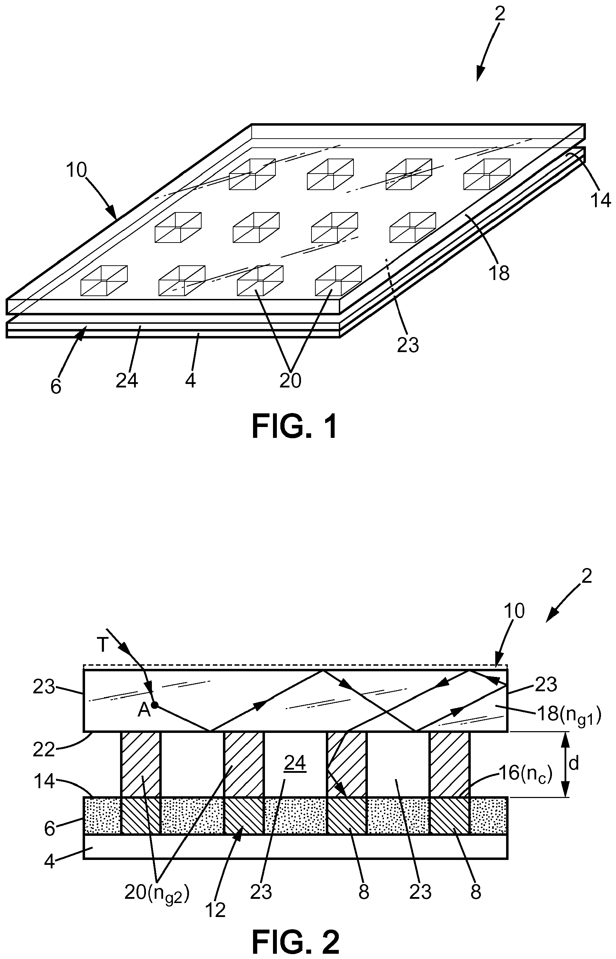

La Figure 1 illustre un dispositif photovoltaïque 2 selon l'invention, configuré pour transformer la lumière en énergie électrique.

En référence aux Figures 1 et 2, le dispositif 2 comprend un substrat 4, un support 6, des cellules photovoltaïques 8, et un guide de lumière 10.

Le dispositif 2 fonctionne sur une plage de longueurs d'onde dite utiles. Cette plage de longueurs d'onde utiles est définie comme la plage spectrale des photons que les cellules 8 sont capables de convertir en électricité. La borne supérieure de cette plage dépend donc de la nature des cellules photovoltaïques 8, et plus précisément du matériau constituant les absorbeurs de ces cellules. La borne inférieure de cette plage est communément fixée à 350 nm car il n'y a quasiment pas de photons de longueur d'onde inférieure à 350 nm arrivant sur Terre.

Cette plage est par exemple de 350 nm à 1200 nm.

Le substrat 4 présente une forme générale de plaque rectangulaire. Il est par exemple réalisé par des méthodes connues. Le substrat 4 est au contact du support 6 et soutient le support 6.

Dans un mode de réalisation, le substrat 4 est pourvu de contacts électriques (non représentés) configurés pour connecter individuellement ou en réseau l'ensemble des cellules photovoltaïques 8 à un circuit extérieur.

Le support 6 présente une forme générale de plaque rectangulaire. Il présente des dimensions latérales et transverses correspondant sensiblement à celles du substrat. Le support 6 est disposé sur le substrat 4 et sensiblement parallèlement au substrat 4. Le substrat 4 et le support 6 sont disposés sensiblement bord à bord.

Le support 6 reçoit les cellules 8. Dans le mode de réalisation des Figures 1 et 2, le support 6 est pourvu de cavités 12 débouchantes dont les ouvertures respectives sont orientées à l'écart du substrat 4. Chaque cavité 12 reçoit une cellule photovoltaïque 8. Les cavités 12 présentent des dimensions sensiblement complémentaires de celles des cellules photovoltaïques 8. Les cavités 12, et donc les cellules 8, sont espacées les uns des autres sur le support. Il est optimal pour les performances du dispositif 2 que l'espacement entre les cellules soit régulier. Par exemple, les cavités 12, et donc les cellules 8, sont agencées selon une disposition matricielle sur la surface du support 6, c'est-à-dire en lignes et en colonnes régulièrement distribuées sur cette surface. Néanmoins, dans certains modes de réalisation, cet espacement est peu régulier, voire aléatoire. Ceci permet notamment de faciliter la fabrication du dispositif 2.

Selon une variante de réalisation, les cellules sont disposées directement sur la surface du support, le support ne présentant pas de cavité 12. L'invention est par la suite décrite de manière non limitative pour des modes de réalisation dans lesquels le support présente des cavités 12.

Par ailleurs, plusieurs réalisations du support 6 sont envisageables.

Dans une réalisation, le support 6 est un réflecteur. Le réflecteur 6 présente une face supérieure (au sens de l'orientation des Figures). Cette face supérieure est une face réfléchissante 14 orientée à l'écart du substrat 4. Plus précisément, la face réfléchissante 14 est orientée en direction du guide de lumière 10. Les cavités 12 débouchent à travers la face réfléchissante 14.

Le réflecteur 6 est par exemple réalisé de manière classique. Par exemple, la surface réfléchissante 14 comprend une couche d'argent Ag, ou d'aluminium Al formée avant ou après la mise en place des cellules 8 et sur laquelle est optionnellement déposée une couche d'oxyde de zinc ZnO dopée ou non à l'Aluminium.

Dans certains modes de réalisation, la face réfléchissante 14 est configurée pour réfléchir une partie seulement du domaine visible. Avantageusement, la plage de longueurs d'onde que la face réfléchissante 14 est alors configurée pour réfléchir, inclut tout ou partie d'une plage de longueurs d'onde d'émission d'un guide primaire du guide de lumière 10. Par exemple, elle est choisie pour inclure la totalité de cette plage de longueurs d'onde d'émission.

Ce guide primaire et sa plage de longueurs d'onde d'émission sont décrits ci-après.

Ceci est avantageux dans certains types d'applications, notamment dans la réalisation de vitrages, et permet notamment d'obtenir un dispositif ayant de faibles pertes optiques dans le cadre de ces applications.

Dans certaines réalisations, le substrat 4 est lui-même transparent aux longueurs d'onde qui ne sont pas réfléchies par le support 6.

Dans certaines réalisations particulières, le support 6 est alternativement ou parallèlement réfléchissant dans une plage de longueurs d'onde choisie du domaine visible, de sorte que le dispositif présente un aspect extérieur ayant une teinte dépendant de ladite plage de longueurs d'onde choisie.

Dans les réalisations dans lesquelles le support 14 est réfléchissant dans une partie du domaine visible incluant tout ou partie d'une plage de longueurs d'onde d'émission du guide primaire, la plage choisie associée à la teinte en question est par exemple choisie pour être disjointe de la plage de longueurs d'onde d'émission du guide primaire.

Dans certains modes de réalisation, la face réfléchissante 14 est configurée pour réfléchir la totalité du domaine visible.

Dans une réalisation qui ne fait pas partie de la présente invention, le support 6 présente la même géométrie que précédemment, mais le support 6 est dépourvu de surface réfléchissante, c'est-à-dire que la face supérieure du support n'est pas réfléchissante. Le support 6 est par exemple constitué d'un matériau transparent dans le domaine visible. Il est par exemple réalisé à partir de verre. Avantageusement, le substrat 4 est lui-même transparent, ce qui permet de rendre l'ensemble du dispositif le plus transparent possible. Ceci est particulièrement avantageux pour certaines applications, comme le vitrage pour le bâtiment, dans lesquelles cette transparence est un critère important.

La description qui suit est donnée de manière non limitative dans le cas où le support 6 est un réflecteur, conformément à la présente invention, mais des alternatives n'appartenant pas à la présente invention sont dérivables, la transposition à un support d'un autre type, par exemple un support transparent, étant immédiate.

Comme indiqué précédemment, les cellules 8 sont respectivement agencées dans l'une des cavités 12 du réflecteur 6. Chaque cellule 8 présente une face supérieure 16 orientée vers le guide de lumière 10 et au niveau de laquelle les photons que la cellule a vocation à transformer en énergie électrique sont reçus en provenance du guide de lumière 10. Les cellules 8 sont agencées dans les cavités 12. Par exemple, les faces 16 des cellules 8 sont sensiblement coplanaires entre elles, et/ou coplanaires avec la face réfléchissante 14 du réflecteur 6. Par exemple, les cellules sont agencées dans le réflecteur selon un montage dit « flush ». Ainsi, les faces supérieures 16 des cellules affleurent au niveau de la face réfléchissante 14. Alternativement, les faces 16 des cellules 8 ne sont pas coplanaires entre elles. En outre, dans certains modes de réalisation, elles sont encaissées dans leur cavité 12 respective, c'est-à-dire que leur face 16 est à un niveau inférieur à celui de l'embouchure de la cavité 12 associée. Dans d'autres modes de réalisation décrits ci-après, les cellules sont en saillie par rapport à leur cavité et au réflecteur.

La face supérieure 16 des cellules 8 est sensiblement plane. La face supérieure 16 des cellules 8 présente un indice de réfraction $n_c$. L'indice de réfraction $n_c$ est par exemple sensiblement égal à 1,9. La face supérieure 16 comprend par exemple une couche d'oxyde transparent conducteur. Cette oxyde peut être de l'oxyde de zinc ZnO, transparent, dopé avec de l'aluminium Al, ou de l'oxyde d'indium et d'étain ITO, ou de l'oxyde d'étain $SnO_2$

Dans un exemple de réalisation, les cellules 8 sont des microcellules.

Avantageusement, les cellules 8 présentent une forme générale cylindrique, et leur face supérieure 16 respective est circulaire. Le diamètre des cellules est alors par exemple compris entre 10 $\mu m$ et 500 $\mu m$.

A noter que par « cylindre », on entend une surface définie par une génératrice passant par un point variable décrivant une courbe plane fermée, ou courbe directrice, tout en gardant une direction fixe. De fait, une forme cylindrique n'est pas nécessairement symétrique de révolution.

Dans certains modes de réalisation tel celui de la Figure 1, les cellules présentent une forme générale cylindrique à section rectangulaire comme visualisé sur la Figure 1. Les cellules 8 présentent alors une largeur et/ou une longueur mesurées dans le plan de leur face supérieure 16 comprise(s) entre 10 $\mu$m et 500 $\mu$m.

Alternativement, les cellules présentent des formes et des faces supérieures 16 respectives de forme quelconque. Les cellules sont par exemple inscrites dans un cylindre de section circulaire et de diamètre compris entre 10 $\mu$m à 500 $\mu$m.

Les cellules 8 sont par exemple des cellules en couches minces, ce qui peut présenter des avantages en termes de facilité de fabrication. Elles sont par exemple de type dit « CIGS » (pour Cu, In, Ga, Se) et de composition, Cu(In, Ga)Se$_2$, c'est-à-dire qu'elles sont réalisées à partir de Cuivre, d'Indium, de Gallium et de Sélénium. Elles peuvent également être de type CdTe ou CZTS, qui sont d'autres cellules en couches minces.

Néanmoins, l'invention n'est pas limitée à un type particulier de cellules. Les cellules peuvent être choisies de façon quelconque parmi les cellules existantes. Par exemple, les cellules pourront être en Silicium cristallin, polycristallin ou amorphe, les cellules à partir de semiconducteur de type III-V, comme par exemple le GaAs, le GaInP ou le GaInAs.

Le guide de lumière 10 est configuré pour recevoir des photons et les guider vers les cellules 8. Le guide de lumière 10 est commun aux cellules 8. En outre, il est au contact de toutes les cellules 8. Le guide de lumière est configuré pour guider les photons en son sein jusqu'à la face supérieure 16 des cellules 8.

Le guide de lumière 10 comprend un guide primaire 18 et une pluralité de guides secondaires 20.

Le guide primaire 18 est un concentrateur fluorescent. Il est configuré pour absorber les photons et réémettre, en réponse, des photons à une autre longueur d'onde. Ceci est décrit plus en détail ci-après.

Le guide primaire 18 présente une forme générale de plaque plane rectangulaire. Cette configuration rend aisée l'assemblage du dispositif et réduit l'encombrement du dispositif.

Le guide primaire 18 présente par exemple une épaisseur de l'ordre du millimètre, ou encore du centimètre.

Le guide primaire 18 est disposé sensiblement parallèlement à la face réfléchissante 14 du réflecteur 6.

Le guide primaire 18 présente une face proximale 22 par rapport aux cellules 8 qui est orientée vers le réflecteur 6. Au vu de l'orientation des Figures 1 et 2, la face proximale 22 correspond à la face inférieure du guide primaire 18. Comme illustré sur les Figures 1 et 2, la face réfléchissante 14 du réflecteur 6 est orientée en direction de la face proximale 22.

La face proximale 22 et la face réfléchissante 14 du réflecteur 6 sont sensiblement parallèles.

Le guide primaire 18 présente des dimensions longitudinales et transverses sensiblement égales à celles du réflecteur 6. Plus précisément, les dimensions du guide primaire, du réflecteur et du substrat sont conditionnées par l'application du dispositif 2. Par exemple, l'aire de la surface proximale 22 du guide primaire (et donc l'aire du réflecteur et du substrat) est de l'ordre de la dizaine de centimètres carrés pour certaines applications, ou de l'ordre du mètre carré pour d'autres applications. Le rapport entre l'aire de la surface proximale 22 et la somme des aires des surfaces supérieures 16 des cellules 8, également connu sous le nom de gain géométrique du dispositif 2, est par exemple compris entre 2 et 100, et vaut par exemple 20. Avantageusement, les cellules 8 sont en regard de la partie centrale du guide primaire 18. Ceci permet de pouvoir ajuster les dimensions du guide primaire 18 sans avoir à modifier la disposition des cellules 8 au niveau du support 6.

Avantageusement, les cellules 8 sont ainsi agencées au niveau du support 6 en face du guide primaire 18 et de sorte que leur face supérieure 16 ne soit pas en regard d'une extrémité latérale du guide primaire 18, c'est-à-dire des arêtes délimitant les faces latérales 23 (Figure 2) du guide primaire 18.

Le guide primaire 18 comprend au moins un colorant ainsi qu'un matériau formant l'essentiel du guide primaire et dans lequel le ou chaque colorant est noyé et distribué de manière homogène. Le colorant est un luminophore ou fluorophore, c'est-à-dire un matériau qui absorbe la lumière dans une première plage de longueurs d'onde, dite plage d'absorption du dispositif 2. En réponse, il réémet en son sein et de manière principalement isotrope des photons dans une deuxième plage de longueurs d'onde, ou plage de longueurs d'onde d'émission. Cette plage est centrée sur une longueur d'onde caractéristique $\lambda$ du dispositif 2

La plage de longueurs d'onde d'absorption désigne la gamme spectrale des photons que le colorant est capable d'absorber. Idéalement, sa borne inférieure correspond à la borne inférieure de la plage de longueurs d'onde utiles, et sa borne supérieure est légèrement plus faible que celle de la plage de longueurs d'onde utiles.

La plage de longueurs d'onde d'émission désigne la gamme spectrale des photons émis par le colorant. Celle-ci est décalée vers les grandes longueurs d'onde par rapport à la plage d'absorption. Elle doit idéalement avoir une borne supérieure coïncidant avec celle de la plage de longueurs d'onde utiles. De plus, cette plage est généralement étroite, de sorte qu'on peut y associer une longueur d'onde particulière autour de laquelle cette plage est centrée -la longueur d'onde caractéristique $\lambda$ -. Comme on le verra par la suite, cette longueur d'onde caractéristique $\lambda$ est utilisée pour définir la hauteur de guides secondaires que comprend le dispositif 2, ainsi que l'espacement entre le guide primaire et le réflecteur. La longueur d'onde caractéristique $\lambda$ du dispositif 2 est fonction du guide primaire 18 et du ou des colorants qu'il contient. Elle est choisie pour être comprise dans une gamme spectrale où les cellules photovoltaïques 8 ont de bonnes performances.

La plage de longueurs d'onde d'absorption et la plage de longueurs d'onde d'émission présentent généralement une gamme de fréquences commune. Toutefois, préférentiellement, cette gamme commune est aussi étroite que possible. Ceci permet de limiter les phénomènes de réabsorption par le guide primaire 18 des photons émis par le guide primaire 18 lui-même, ces réabsorptions engendrant des pertes.

La face réfléchissante 14 du réflecteur 6 est choisie pour réfléchir de manière optimale les photons présentant une longueur d'onde comprise dans la plage de longueurs d'onde d'émission du guide primaire.

Préférentiellement, le rendement de luminescence du colorant, c'est à dire le rapport entre le nombre de photons réémis par le colorant sur le nombre de photons absorbés, est supérieur à 90% et avantageusement à 95%.

Selon une première variante, le guide d'onde primaire est composé d'un ou plusieurs polymères dopé(s) par un ou plusieurs colorants. Par exemple, le guide primaire est réalisé à partir de Polyméthacrylate de Méthyle, ou PMMA. Dans certains modes de réalisation, le colorant est réalisé à partir de molécules organiques telles que par exemple du Lumogen®, commercialisé par la société BASF, et est par exemple du Lumogen® RED 305. Alternativement, le colorant est réalisé à partir de rhodamine, de pérylène, de 4-butylamino-N-allyl-1,8-naphthaliniide, de Poly(9,9-di-(2-ethylhexyl)-9H-fluorene-2,7-vinylene, de poly((9,9-di-(2-ethylhexyl)-9H-fluorene-2,7-vinylene)-co-(1-methoxy-4-(2-ethylhexyloxy)-2,5 ou de chélates d'ions lanthanides.

Alternativement, le colorant est réalisé à partir de nano-cristaux de semi-conducteurs (connus sous le nom anglophone de « Quantum dots »), tels que par exemple des nanoparticules de PbS, PbSe ou des structures de type cœur/coquille de CdSe/ZnS, CdSe/CdS, CdSe/CdS/CdZnS/ZnS, CdTe/CdSe.

Alternativement, le colorant est réalisé à partir de composés hybrides organiques/inorganiques.

Dans certains modes de réalisation, le colorant est réalisé à partir de plusieurs des éléments décrits ci-dessus, ce qui permet d'élargir la plage d'absorption du concentrateur.

Selon une autre variante, le guide primaire est un oxyde dopé par des éléments luminescents.

Dans d'autres modes de réalisation, le colorant est réalisé à partir de nanoparticules d'oxydes dopées par des terres rares, comme l'Othovanadate d'Yttrium dopé par de l'Europium, ou des oxydes dopés au Néodyme (Nd3+) ou à l'Ytterbium (Yb 3+) ou dopés à d'autres terres rares, par exemple aux lanthanides.

Le guide primaire 18, et donc sa face proximale 22, présente un indice de réfraction $n_{g1}$. L'indice de réfraction $n_{g1}$ est par exemple sensiblement égal à 1,5.

Selon l'invention, la face proximale 22 du guide primaire 18 est à l'écart du réflecteur 6. Le dispositif 2 comporte une ou plusieurs zones 23 situées entre les cellules et comportant un matériau 24 d'indice de réfraction inférieur à celui de la surface proximale 22 du guide primaire 18. Le matériau 24 remplit l'espace délimité entre le réflecteur 6 et le guide primaire 18 et s'étendant entre les cellules 8. La ou les zones 23 sont situées entre deux portions appartenant respectivement au guide primaire 18 et au réflecteur 6 et qui sont en regard l'une de l'autre.

Préférentiellement, le matériau 24 à l'indice de réfraction le plus faible possible. Le matériau 24 préférentiel est donc de l'air (indice de réfraction égal à 1).

La présence du matériau 24 a pour effet d'induire une réflexion de Fresnel à l'interface entre le guide primaire 18 et le matériau 24, c'est-à-dire au niveau de la face proximale 22. Cette réflexion est spéculaire et d'efficacité sensiblement égale à 100% pour les photons ayant un angle d'incidence supérieur ou égal à un angle dit critique. On parle alors de réflexion interne totale, d'acronyme anglophone TIR pour « Total Internai Reflection ». La valeur de cet angle ne dépend que des indices de réfraction des matériaux formant l'interface, c'est-à-dire du guide primaire 18 et du matériau 24. Pour que le phénomène de réflexion interne total ait lieu il faut que la lumière passe d'un milieu d'indice élevé à un milieu d'indice de réfraction plus faible, ce qui explique l'ajout du matériau 24 en dessous du guide primaire. Dans les modes de réalisation où le matériau 24 est de l'air, et le matériau du guide d'onde primaire a un indice de réfraction de 1.5, l'angle critique vaut alors sensiblement 42°, ce qui correspond à 75% des photons incidents par suite réfléchis par TIR et 25% de photons non réfléchis pour une émission isotrope, ce qui est le cas ici.

Préférentiellement, le matériau 24 présente un indice de réfraction égal ou sensiblement égal à un. Ceci a pour effet de minimiser la valeur de l'angle critique et donc maximiser la proportion des photons réfléchis par réflexion interne totale.

En variante, le matériau 24 est un matériau poreux, par exemple réalisé à partir de nanostructures de $SiO_2$ ou de $TiO_2$, de façon à minimiser l'indice de réfraction effectif. Alternativement, le matériau 24 est réalisé à partir d'un polymère d'indice de réfraction inférieur à 1,4, et valant par exemple 1,3. En variante encore, le matériau 24 est réalisé à partir de Fluorure de Magnésium $MgF_2$, ou encore d'oxyde de silice $SiO_2$.

Préférentiellement, la distance d entre la face proximale 22 du guide primaire 18 et le support 6 est supérieure ou égale à la longueur d'onde caractéristique $\lambda$ du dispositif 2. Ceci a pour effet de minimiser les effets non-linéaires du comportement des photons induits par le fait que cette distance puisse ne pas être négligeable par rapport à la longueur d'onde des photons après leur émission par le guide primaire 18. Préférentiellement, la distance d entre la face proximale 22 et le réflecteur 6 est supérieure ou égale à un multiple strictement supérieur à un de la longueur d'onde caractéristique $\lambda$. Ceci permet de minimiser plus avant les effets de non-linéarité précités. Par exemple, la longueur d'onde caractéristique du dispositif 2 peut être d'environ 1 μm et la distance entre la face proximale 22 et le réflecteur 6 est par exemple prise supérieure ou égale à deux, trois ou quatre fois cette longueur, et vaut par exemple 5 μm.

En outre, préférentiellement, la distance entre la face proximale 22 et le réflecteur 6 est inférieure ou égale à quelques multiples de la longueur d'onde caractéristique λ du dispositif 2, par exemple à vingt fois cette longueur d'onde. Ceci permet notamment de limiter les phénomènes de déperdition des photons par les flancs des guides secondaires 20, ainsi que de minimiser la probabilité d'occurrence de réflexions au niveau des faces latérales des guides secondaires 20, comme on le verra par la suite. Ainsi, par exemple, la distance entre la face proximale 22 et le réflecteur 6 est prise inférieure ou égale à 20 μm, et est par exemple comprise entre 5 μm et 10 μm.

Préférentiellement, les zones 23 forment une unique zone 23 continue et au contact de la face proximale 22 sur sensiblement toute la surface de la face proximale 22 qui n'est pas en regard d'un guide secondaire 20. Ceci a pour effet d'améliorer l'efficacité des réflexions sur une surface d'aire maximale.

Les guides secondaires 20 sont transparents. Ils sont respectivement associés à l'une des cellules 8. Préférentiellement, les guides secondaires 20 sont identiques les uns aux autres. Ceci facilite leur fabrication et donc celle du dispositif 2 de façon générale.

Chaque guide secondaire 20 se présente sous la forme d'un plot. Chaque guide secondaire 20 est interposé entre la face proximale 22 du guide primaire 18 et la face supérieure 16 d'une cellule 8. Les guides secondaires 20 maintiennent la face proximale 22 du guide primaire 18 à l'écart du réflecteur 6. Les guides secondaires 20 sont séparés les uns des autres latéralement par le matériau 24.

Préférentiellement, chaque guide secondaire 20 présente une face, ou base, au contact de la cellule 8 associée qui présente une forme sensiblement identique à celle de la face supérieure 16 de la cellule 8. Ceci a pour effet de maximiser le pourcentage des photons qui passent du guide primaire 18 vers les guides secondaires 20 et des guides secondaires 20 vers les cellules 8. Par exemple, chaque guide secondaire présente une forme générale cylindrique ou prismatique de section quelconque et dont la base présente une forme sensiblement identique à celle de la face supérieure 16 de la cellule 8 associée. Par exemple, comme illustré sur la Figure 2, pour des cellules 8 à face supérieure 16 rectangulaire, chaque guide secondaire 20 présente une forme prismatique droite de section rectangulaire présentant des dimensions sensiblement identiques à celles de la face supérieure 16 des cellules. Alternativement, pour ces cellules 8 de forme cylindrique et de section circulaire, les guides secondaires 20 présentent une forme générale cylindrique également de section circulaire.

Alternativement, les guides secondaires 20 peuvent présenter des flancs incurvés ou bombés, une forme trapézoïdale ou autre.

Chaque guide secondaire 20 est agencé au contact de la face supérieure 16 de la cellule 8 associée, la base du guide secondaire 20 étant agencée au contact de la face supérieure 16 et bord à bord, comme illustré sur les Figures 1 et 2.

Les guides secondaires 20 sont par exemple réalisés à partir de résine photosensible. Par exemple, la résine photosensible est la résine commercialisée sous le nom AZ® nLOF™ 2070 par la société Microchemicals, ou la résine 40XT, ou la résine SU8.

Les guides secondaires 20 présentent un indice de réfraction $n_{g2}$. L'indice de réfraction $n_{g2}$ est supérieur à l'indice de réfraction $n_{g1}$ du guide primaire 18. En outre, l'indice de réfraction $n_{g2}$ des guides secondaires 20 est inférieur à l'indice de réfraction $n_c$ des faces supérieures 16 des cellules 8. Ceci a pour effet de favoriser le transfert de photons vers les cellules 8, les guides secondaires fournissant un anti-reflet pour les cellules du fait de leur indice intermédiaire entre celui du guide primaire et celui des cellules.

Préférentiellement, l'indice de réfraction $n_{g2}$ des guides secondaires 20 est sensiblement égal à la moyenne géométrique de l'indice de réfraction $n_{g1}$ du guide primaire 18 et de l'indice de réfraction $n_c$ des faces supérieures 16 des cellules 8. Ceci a pour effet de simultanément favoriser le transfert des photons depuis le guide primaire 18 vers les guides secondaires 20 et le transfert des photons depuis les guides secondaires 20 vers les cellules 8. En d'autres termes, préférentiellement, on a la relation :

$$n_{g2} \cong \sqrt{n_{g1} * n_c}$$

Par exemple, l'indice $n_{g1}$ vaut sensiblement 1,5 et l'indice $n_c$ vaut sensiblement 1,9. Préférentiellement, l'indice $n_{g2}$ vaut alors sensiblement 1,69.

Le principe de fonctionnement du dispositif 2 va maintenant être décrit en référence aux Figures 1 et 2.

Lors du fonctionnement du dispositif 2, le guide primaire 18 est illuminé par des photons provenant de son environnement.

En référence à la Figure 2 qui illustre un exemple de trajet optique T, les photons environnant le dispositif 2 pénètrent dans le guide primaire 18. Comme indiqué précédemment, ils sont absorbés par le guide primaire 18. Certains photons sont par exemple absorbés au niveau d'un point A dans l'épaisseur du guide primaire 18. En réponse, le guide primaire 18 émet, depuis le point A, des photons de manière isotrope dans le guide primaire 18, c'est-à-dire dans toutes les directions. Ces photons sont émis à une longueur d'onde appartenant à la plage d'émission du guide primaire 18.

Une fois émis au sein du guide primaire 18, ces photons s'y déplacent en direction d'une interface du guide primaire 18.

Les photons arrivant au niveau d'une zone de la face proximale 22 en regard d'un guide secondaire 20 passent dans celui-ci puis parviennent, pour tout ou partie d'entre eux, à la face supérieure 16 de la cellule 8 associée, comme décrit ci-après.

Comme illustré par le trajet optique T, les photons arrivant au niveau d'une interface du guide primaire 18 dans une zone qui n'est pas en regard d'un guide secondaire 20 sont réfléchis. Plus précisément, de manière connue, à chaque réflexion, seule une partie des photons est réfléchie, l'autre partie de ces photons s'échappant du guide primaire 18. Pour les réflexions ayant lieu au niveau de la face proximale 22, les photons qui ne sont pas réfléchis se propagent en direction du réflecteur 6, où ils sont réfléchis en direction du guide primaire 18. Ils y pénètrent et s'y propagent de nouveau.

Selon l'invention, comme indiqué précédemment, la proportion des photons effectivement réfléchis au niveau de la face proximale 22 est augmentée du fait de la présence des zones 23 comprenant le matériau 24. En effet, dans un cas de figure avec le réflecteur positionné directement sous le guide primaire 18, tous les rayons seraient réfléchis avec le coefficient de réflexion du réflecteur, qui est non parfait. Avec la présence du matériau 24, une grande partie des rayons est parfaitement réfléchie par réflexion interne totale. Ceux qui s'échappent rencontrent le réflecteur 6 et sont donc réfléchis avec le taux de sa face réfléchissante et rentrent de nouveau dans le guide primaire.

Le déplacement dans le guide primaire 18 des photons, issus ou non d'une ou plusieurs réflexions sur la face réfléchissante 14 du réflecteur, se poursuit jusqu'à leur arrivée au sein du guide primaire 18 au niveau de la face proximale 22 dans une zone située en regard d'un guide secondaire 20. Du fait des valeurs des indices de réfraction $n_{g1}$, $n_{g2}$ et $n_c$, les photons pénètrent alors dans le guide secondaire 20 en question dans lequel ils se déplacent en direction de la cellule 8 correspondante. En fonction de l'angle sous lequel un photon pénètre dans un guide secondaire 20, il peut être sujet à une ou plusieurs réflexions au niveau du bord latéral du guide secondaire 20. Comme précédemment, seule une partie des photons subissant ces réflexions se réfléchit effectivement, une autre partie passant dans le matériau 24. En fonction de leur trajectoire et de leur position dans le dispositif 2, notamment de leur proximité avec un bord du dispositif 2, une fois sortis du guide secondaire 20, ces photons pénètrent dans un autre guide secondaire 20 (avec ou sans réflexion par le réflecteur 6), pénètrent de nouveau dans le guide primaire 18 (après réflexion sur le réflecteur 6) ou s'échappent du dispositif 2 (avec ou sans réflexion sur le réflecteur 6). Les photons parvenant à la face supérieure 16 d'une cellule 8 sont alors convertis en énergie électrique par la cellule 8.

Dans les modes de réalisation dans lesquels le support 6 est réfléchissant seulement pour une partie du spectre, les photons dont la longueur d'onde se trouve dans la plage de longueurs d'onde réfléchies par le support 6 se comportent comme décrit ci-dessus. Les photons ayant une longueur d'onde qui n'est pas réfléchie par le support ne sont alors pas réfléchis par le support et s'échappent du dispositif lors du fonctionnement de ce dernier.

Dans les modes de réalisation dans lesquels le support 6 est transparent, les photons ne sont pas réfléchis par le support 6 lors du fonctionnement du dispositif.

La fabrication du dispositif 2 va maintenant être décrite en référence aux Figures 1 et 2.

Dans un premier temps, on fabrique le substrat 4, le support 6 et les cellules 8 par tout procédé connu et on les agence comme décrit précédemment. En d'autres termes, on agence le support 6 sur le substrat 4 et on dispose les cellules 8 au niveau du support 6.

Dans certains modes de réalisation, la face supérieure 16 des cellules 8 comprend une couche d'oxyde de zinc ZnO dopée à l'Aluminium Al. Aussi, dans les modes de réalisation correspondants, on dépose cette couche sur les cellules 8 une fois celles-ci agencées au niveau du support, soit sélectivement uniquement sur les cellules 8, soit aussi bien sur les cellules 8 que sur la face réfléchissante 14 du réflecteur 6.

En outre, on fabrique les guides secondaires 20, par exemple par photolithographie optique. Le positionnement des guides secondaires est alors réalisé pendant la photolithographie. Enfin, on agence la face proximale 22 du guide primaire 18 au contact de l'extrémité libre des guides secondaires 20. Optionnellement, on réalise également un recuit afin de solidariser les guides secondaires 20 au guide primaire 18, ce qui améliore la tenue mécanique du dispositif 2.

En variante, on forme tout ou partie des guides secondaires 20 directement au contact des cellules 8 par voie électrochimique. Plus particulièrement, après agencement des cellules 8 sur le réflecteur 6, on réalise les guides secondaires 20 par électrodépôt d'oxyde de zinc ZnO, qu'on dépose sélectivement sur la surface des cellules 8.

Dans les modes de réalisation correspondants, les guides secondaires 20 formés directement sur les cellules 8 sont réalisées à partir d'oxyde de zinc ZnO.

Le dispositif 2 selon l'invention a été mis en œuvre avec un gain géométrique de l'ordre de 20. Il a ainsi été observé une multiplication par trois du facteur de concentration du dispositif par rapport à un dispositif de l'état de la technique. Par exemple, le facteur de concentration d'un dispositif de l'état de la technique dans lequel le guide primaire est accolé au réflecteur a été mesuré à 1,8, tandis que le facteur de concentration du dispositif 2 selon l'invention a été mesuré à 5,3.

Ceci s'explique par le gain d'efficacité direct découlant de l'amélioration de l'efficacité des réflexions au niveau de la face proximale 22 du guide primaire 18, mais aussi d'un gain d'efficacité indirect au niveau de la face supérieure du guide primaire 18 résultant du caractère spéculaire des réflexions au niveau de la face proximale 22, pour des photons arrivant avec un angle d'incidence suffisant pour être réfléchis par réflexion interne totale.

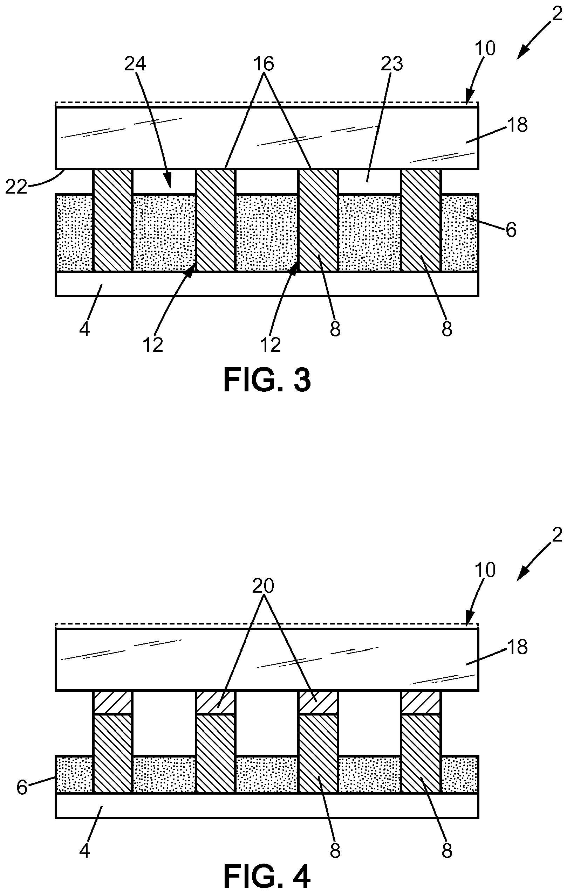

En référence à la Figure 3, dans une variante de l'invention, les cellules 8 font saillie du réflecteur 6 en direction du guide primaire 18. La surface proximale 22 est agencée directement au contact des cellules 8. En d'autres termes, le dispositif 2 est dépourvu de guide secondaire 20. Les cellules 8 maintiennent le guide primaire 18 à l'écart du réflecteur 6.

Dans ce mode de réalisation, les cellules 8 sont par exemple formées directement dans les cavités 12 du réflecteur 6, par exemple par dépôt. Alternativement, elles sont formées directement sur le réflecteur 6 qui est dépourvu de cavité 12. Lors de la fabrication du dispositif 2, la face réfléchissante 14 du réflecteur 6 est par exemple formée après la formation des cellules 8 par dépôt. Ceci permet de minimiser l'impact de la formation des cellules 8 sur la qualité de la face réfléchissante 14 du réflecteur 6.

Du fait qu'il ne comprend pas de guide secondaire 20, le dispositif 2 selon cette variante est moins coûteux et plus aisé à fabriquer.

En référence à la Figure 4, dans un autre mode de réalisation, les cellules 8 sont en saillie par rapport au réflecteur 6 et le dispositif 2 comprend des guides secondaires 20 tels que décrit précédemment. Ce mode de réalisation permet de bénéficier de la saillie des cellules 8 pour limiter les dimensions des guides secondaires 20 et donc d'également simplifier la fabrication du dispositif 2.

Dans une autre variante (non représentée), les modes de réalisation décrits ci-dessus sont combinés. Par exemple, la face supérieure de certaines cellules 8 affleure au niveau de la face réfléchissante du réflecteur 6 tel qu'illustré sur la Figure 2, tandis que d'autres cellules font saillie hors de réflecteur. Le dispositif 2 comprend alors des guides secondaires 20 d'une première taille interposés entre les cellules 8 dont la face supérieure affleure et la surface proximale 22 du guide primaire, et des guides secondaires 20 d'une deuxième taille interposés entre les cellules faisant saillie et la surface proximale. Les sommets de tous les guides secondaires sont alors sensiblement à la même hauteur, le guide primaire étant au contact de chacun d'entre eux.

Dans un autre exemple de cette variante, le guide primaire 18 est agencé au contact direct des cellules faisant saillie hors du réflecteur. En outre, les cellules 8 dont la face supérieure affleure sont alors chacune couplées à un guide secondaire 20 tel que décrit précédemment et interposé entre la cellule 8 en question et la surface proximale 22.

D'autres modes de réalisation du dispositif 2 selon l'invention sont également envisageables.

Par exemple, dans certains modes de réalisation, la face supérieure du guide primaire 18 est recouverte d'un filtre coupe-bande (en pointillés sur la Figure 2) configuré pour laisser passer au maximum les photons environnants dans le guide primaire 18 mais pour empêcher la sortie des photons par la face supérieure du guide primaire 18, en particulier des photons réémis par le guide primaire 18 et ayant une longueur d'onde située dans la plage d'émission du guide primaire. Aussi, le filtre présente de bonnes propriétés de réflexion des photons présentant des longueurs situées autour de la longueur d'onde caractéristique, et une forte transmission pour les autres longueurs d'onde.

En outre, parmi les dispositifs optiques permettant de concentrer la lumière sur des dispositifs photovoltaïques, on distingue les dispositifs imageants, qui permettent l'obtention d'une image d'un objet à travers son système optique, et donc dans ce cas une image du soleil sur la cellule, et les dispositifs non imageants, qui concentrent quant à eux la lumière sans former d'image.

Les dispositifs imageants ont la particularité de ne concentrer la lumière solaire que si elle arrive de façon directe sur le dispositif considéré, c'est-à-dire si elle est orientée selon l'axe formé par le soleil et l'optique du dispositif, et ne peuvent pas utiliser la lumière diffuse, qui elle arrive selon des directions quelconques, par exemple à cause de phénomènes de diffusion générés par les nuages.

Les dispositifs non imageants sont peu sensibles à la direction de la lumière solaire incidente et présentent donc l'avantage de ne pas avoir à suivre précisément la course du soleil par des systèmes spéciaux.

Aussi, préférentiellement, le dispositif 2 est un dispositif non imageant. Il est alors fixé sur son support de manière immobile. Ceci permet d'affranchir le dispositif d'un mécanisme d'orientation configuré pour orienter ce dernier en fonction de la course du Soleil, ce qui est nécessaire pour les dispositifs imageants. Le coût du dispositif 2 est donc substantiellement diminué comparativement à un dispositif imageant.

## Revendications

1. Dispositif photovoltaïque comprenant :

   - une pluralité de cellules photovoltaïques (8), distantes les unes des autres,
   - un support (6) recevant les cellules, le support (6) étant un réflecteur présentant une face réfléchissante (14), et
   - un guide de lumière (10) au contact desdites cellules et comportant un guide primaire (18) ayant une face proximale (22) par rapport aux cellules, la face proximale (22) étant orientée vers les cellules (8) et ladite face réfléchissante (14),

   **caractérisé en ce que** le dispositif photovoltaïque comporte, entre les cellules, des zones (23) situées entre le support et le guide primaire et comprenant un matériau (24) d'indice de réfraction inférieur à celui de la face proximale, le matériau étant au contact de ladite face proximale ; et

**en ce que**

- le support (6) et la face proximale (22) du guide primaire sont espacés d'une distance (d) comprise entre 1 μm et 20 μm

et/ou

- le guide primaire (18) est un concentrateur fluorescent et la distance (d) entre le support et la face proximale (22) du guide primaire est sensiblement égale à un multiple supérieur ou égal à deux d'une longueur d'onde caractéristique (λ) du dispositif et correspondant à une longueur d'onde privilégiée d'émission du guide primaire (18).

2. Dispositif selon la revendication 1, **caractérisé en ce qu'**une ou plusieurs cellules photovoltaïques (8) sont agencées en saillie par rapport au support (6) en direction du guide primaire (18), le guide primaire étant au contact desdites cellules et maintenu à l'écart du support au moins par lesdites cellules.

3. Dispositif photovoltaïque selon l'une des revendications précédentes, **caractérisé en ce que** ledit matériau (24) est de l'air.

4. Dispositif photovoltaïque selon l'une des revendications précédentes, **caractérisé en ce que** le guide de lumière (10) comprend une pluralité de guides secondaires (20) séparés les uns des autres par ledit matériau (24), chaque guide secondaire (20) étant interposé entre la face proximale (22) du guide primaire et une cellule photovoltaïque (8).

5. Dispositif photovoltaïque selon la revendication 4, **caractérisé en ce que** les guides secondaires (20) maintiennent la face proximale du guide primaire à l'écart du support (6) au moins dans lesdites zones.

6. Dispositif photovoltaïque selon la revendication 4 ou 5, **caractérisé en ce que** chaque guide secondaire (20) présente une face disposée au contact de la surface (16) de la cellule photovoltaïque correspondante et présentant des dimensions sensiblement égales aux dimensions de la surface de ladite cellule, ladite face d'un guide secondaire (20) donné étant disposée sensiblement bord à bord en regard de la surface (16) de la cellule photovoltaïque correspondante.

7. Dispositif photovoltaïque selon l'une des revendications 4 à 6, **caractérisé en ce que** l'un au moins des guides secondaires (20) se présente sous la forme d'un plot de forme générale prismatique droite dont la base est de dimensions sensiblement égales à celles de la surface de la cellule photovoltaïque correspondante.

8. Dispositif photovoltaïque selon l'une des revendications 4 à 7, **caractérisé en ce que** le ou chaque guide secondaire présente un indice de réfraction compris entre l'indice de réfraction du guide primaire et l'indice de réfraction de la surface de la cellule photovoltaïque correspondante.

9. Procédé de fabrication d'un dispositif photovoltaïque comprenant :

- une pluralité de cellules photovoltaïques (8), distantes les unes des autres,
- un support (6), le support (6) étant un réflecteur présentant une face réfléchissante (14) au niveau duquel les cellules photovoltaïques (8) sont agencées, et
- un guide de lumière (10) au contact desdites cellules photovoltaïques et comportant un guide primaire (18) ayant une face proximale (22) par rapport aux cellules, la face proximale étant orientée vers les cellules et ladite face réfléchissante,

dans lequel :

- on agence les cellules photovoltaïques (8) au niveau du support (6), et
- on agence le guide de lumière (10) au contact des cellules photovoltaïques (8) en ménageant, entre les cellules photovoltaïques (8), des zones (23) situées entre le guide primaire (18) et le support (6) et comprenant un matériau (24) d'indice de réfraction inférieur à celui de la face proximale (22), ledit matériau étant agencé au contact de ladite face proximale.
- on agence le guide primaire (22) de sorte que sa face proximale est espacée du support (6) d'une distance (d) comprise entre 1 μm et 20 μm et/ou le guide primaire est un concentrateur fluorescent et on agence le guide primaire (22) de sorte que sa face proximale est espacée du support (6) d'une distance (d) sensiblement égale à un multiple supérieur ou égal à deux d'une longueur d'onde caractéristique (λ) du dispositif et correspondant à une longueur d'onde privilégiée d'émission du guide primaire (18).

10. Procédé de fabrication d'un dispositif photovoltaïque selon la revendication 9, **caractérisé en ce qu'**on obtient un ou plusieurs guides secondaires (20) transparents qu'on interpose chacun entre le guide primaire (18) et une cellule photovoltaïque (8).

11. Procédé de fabrication d'un dispositif photovoltaïque selon la revendication 10, **caractérisé en ce que** chaque guide secondaire (20) est formé par dépôt directement au contact de la cellule photovoltaïque (8) correspondante.

**12.** Procédé de fabrication d'un dispositif photovoltaïque selon l'une des revendications 9 à 11, **caractérisé en ce qu'**on forme par dépôt, au niveau du support (6), tout ou partie des cellules photovoltaïques (8) de telle sorte que les cellules photovoltaïques correspondantes soient en saillie par rapport au support, et **en ce qu'**on dispose le guide primaire (18) au contact desdites cellules en saillie.

**Patentansprüche**

**1.** Photovoltaikvorrichtung, umfassend:

- eine Vielzahl von zueinander beabstandeten Photovoltaikzellen (8),
- einen Träger (6), der die Zellen aufnimmt, wobei der Träger (6) ein Reflektor mit einer reflektierenden Fläche (14) ist, und
- einen Lichtleiter (10), der in Kontakt mit den Zellen steht und einen Primärleiter (18) mit einer proximalen Fläche (22) bezüglich der Zellen aufweist, wobei die proximale Fläche (22) zu den Zellen (8) und der reflektierenden Fläche (14) hin ausgerichtet ist,

dadurch gekennzeichnet, dass die Photovoltaikvorrichtung zwischen den Zellen Bereiche (23) umfasst, die zwischen dem Träger und dem Primärleiter angeordnet sind, und ein Material (24) mit einem Brechungsindex umfassen, der niedriger ist als derjenige der proximalen Fläche, wobei das Material in Kontakt mit der proximalen Fläche steht; und dadurch, dass
- der Träger (6) und die proximale Fläche (22) des Primärleiters um einen Abstand (d) zwischen 1 $\mu$m und 20 $\mu$m beabstandet sind und/oder
- der Primärleiter (18) ein Fluoreszenzkonzentrator ist und der Abstand (d) zwischen dem Träger und der proximalen Fläche (22) des Primärleiters im Wesentlichen gleich einem Vielfachen größer oder gleich zwei einer charakteristischen Wellenlänge ($\lambda$) der Vorrichtung ist und einer bevorzugten Emissionswellenlänge des Primärleiters (18) entspricht.

**2.** Vorrichtung nach Anspruch 1, **dadurch gekennzeichnet, dass** eine oder mehrere Photovoltaikzellen (8) von dem Träger (6) in Richtung des Primärleiters (18) abstehend angeordnet sind, wobei der Primärleiter in Kontakt mit den Zellen steht und zumindest durch die Zellen von dem Träger ferngehalten wird.

**3.** Photovoltaikvorrichtung nach einem der vorhergehenden Ansprüche, **dadurch gekennzeichnet, dass** das Material (24) Luft ist.

**4.** Photovoltaikvorrichtung nach einem der vorhergehenden Ansprüche, **dadurch gekennzeichnet, dass** der Lichtleiter (10) eine Vielzahl von Sekundärleitern (20) umfasst, die durch das Material (24) voneinander getrennt sind, wobei jeder Sekundärleiter (20) zwischen der proximalen Fläche (22) des Primärleiters und einer Photovoltaikzelle (8) angeordnet ist.

**5.** Photovoltaikvorrichtung nach Anspruch 4, **dadurch gekennzeichnet, dass** die Sekundärleiter (20) die proximale Fläche des Primärleiters zumindest in den genannten Bereichen vom Träger (6) fernhalten.

**6.** Photovoltaikvorrichtung nach Anspruch 4 oder 5, **dadurch gekennzeichnet, dass** jeder Sekundärleiter (20) eine Fläche aufweist, die in Kontakt mit der Oberfläche (16) der entsprechenden Photovoltaikzelle angeordnet ist und Abmessungen aufweist, die im Wesentlichen gleich den Abmessungen der Oberfläche der genannten Zelle sind, wobei die genannte Fläche eines gegebenen Sekundärleiters (20) im Wesentlichen Kante an Kante bezüglich der Oberfläche (16) der entsprechenden Photovoltaikzelle angeordnet ist.

**7.** Photovoltaikvorrichtung nach einem der Ansprüche 4 bis 6, **dadurch gekennzeichnet, dass** wenigstens einer der Sekundärleiter (20) die Form eines Zapfens mit allgemein gerader prismatischer Form aufweist, dessen Basis Abmessungen aufweist, die im Wesentlichen denen der Oberfläche der entsprechenden Photovoltaikzelle entsprechen.

**8.** Photovoltaikvorrichtung nach einem der Ansprüche 4 bis 7, **dadurch gekennzeichnet, dass** der oder jeder Sekundärleiter einen Brechungsindex zwischen dem Brechungsindex des Primärleiters und dem Brechungsindex der Oberfläche der entsprechenden Photovoltaikzelle aufweist.

**9.** Verfahren zur Herstellung einer Photovoltaikvorrichtung, umfassend:

- eine Mehrzahl von zueinander beabstandeten Photovoltaikzellen (8),
- einen Träger (6), wobei der Träger (6) ein Reflektor mit einer reflektierenden Fläche (14) ist, an der die Photovoltaikzellen (8) angeordnet sind, und
- einen Lichtleiter (10), der mit den Photovoltaikzellen in Kontakt steht und einen Primärleiter (18) mit einer bezüglich der Zellen proximalen Fläche (22) umfasst, wobei die proximale Fläche den Zellen und der reflektierenden Fläche zugewandt ist,

wobei:

- die Photovoltaikzellen (8) am Träger (6) angeordnet werden, und
- der Lichtleiter (10) in Kontakt mit den Photovoltaikzellen (8) angeordnet wird, durch Einrichten von Bereichen (23) zwischen den Photovoltaikzellen (8), die sich zwischen dem Primärleiter (18) und dem Träger (6) befinden und ein Material (24) mit einem niedrigeren Brechungsindex als dem der proximalen Fläche (22) umfassen, wobei das Material in Kontakt mit der proximalen Fläche angeordnet wird,
- der Primärleiter (22) derart angeordnet wird, dass seine proximale Fläche zu dem Träger (6) um einen Abstand (d) zwischen 1 $\mu$m und 20 $\mu$m beabstandet ist und/oder der Primärleiter ein Fluoreszenzkonzentrator ist und der Primärleiter (22) derart angeordnet wird, dass seine proximale Fläche zu dem Träger (6) um einen Abstand (d) beabstandet ist, der im Wesentlichen gleich einem Vielfachen größer als oder gleich zwei einer charakteristischen Wellenlänge ($\lambda$) der Vorrichtung ist und einer bevorzugten Wellenlänge der Emission des Primärleiters (18) entspricht.

10. Verfahren zur Herstellung einer Photovoltaikvorrichtung nach Anspruch 9, **dadurch gekennzeichnet, dass** ein oder mehrere transparente Sekundärleiter (20) erhalten werden, welche jeweils zwischen dem Primärleiter (18) und einer Photovoltaikzellen (8) angeordnet werden.

11. Verfahren zur Herstellung einer Photovoltaikvorrichtung nach Anspruch 10, **dadurch gekennzeichnet, dass** jeder Sekundärleiter (20) durch Aufbringen in direktem Kontakt mit der entsprechenden Photovoltaikzelle (8) gebildet wird.

12. Verfahren zur Herstellung einer Photovoltaikvorrichtung nach einem der Ansprüche 9 bis 11, **dadurch gekennzeichnet, dass** alle oder ein Teil der Photovoltaikzellen (8) durch Aufbringen auf dem Träger (6) derart gebildet werden, dass die entsprechenden Photovoltaikzellen bezüglich des Trägers überstehen, und dass der Primärleiter (18) in Kontakt mit den überstehenden Zellen angeordnet wird.

## Claims

1. Photovoltaic device comprising:

   - a plurality of photovoltaic cells (8), separated from each other;
   - a support (6) receiving the cells, the support (6) being a reflector having a reflecting surface (14); and
   - a light guide (10) in contact with said cells and comprising a primary guide (18) with a surface (22) that is proximal to the cells, where the proximal surface (22) is oriented towards the cells (8) and said reflecting surface (14),
**characterized in that** the photovoltaic device comprises, between the cells, areas (23) located between the support and the primary guide which comprise a material (24) with an index of refraction less than that of the proximal surface, where the material is in contact with said proximal surface;
and **in that**
- the support (6) and the proximal surface (22) of the primary guide are separated by a distance (d) included between 1 $\mu$m and 20 $\mu$m
and/or
- the primary guide (18) is a fluorescent concentrator and the distance (d) between the support and the proximal surface (22) of the primary guide (6) is substantially equal to a multiple greater than or equal to two of a characteristic wavelength ($\lambda$) of the device and corresponding to a preferred wavelength of emission of the primary guide (18).

2. Device according to claim 1, **characterized in that** one or more photovoltaic cells (8) are arranged projecting from the support (6) towards the primary guide (18), where the primary guide is in contact with said cells and kept separated from the support at least by said cells.

3. Photovoltaic device according to any one of the preceding claims, **characterized in that** said material (24) is air.

4. Photovoltaic device according to any one of the preceding claims, **characterized in that** the light guide (10) comprises a plurality of secondary guides (20) separated from each other by said material (24) where each secondary guide (20) is interposed between the proximal surface (22) of the primary guide and a photovoltaic cell (8).

5. Photovoltaic device according to claim 4, **characterized in that** the secondary guides (20) keep the proximal surface of the primary guide away from the support (6) at least in said areas.

6. Photovoltaic device according to claim 4 or 5, **characterized in that** each secondary guide (20) has a surface arranged in contact with the surface (16) of the corresponding photovoltaic cell and having dimensions substantially equal to the dimensions of the surface of said cell, where said surface of a given secondary guide (20) is arranged substantially edge to edge facing the surface (16) of the corresponding photovoltaic cell.

**7.** Photovoltaic device according to one of claims 4 to 6, **characterized in that** at least one of the secondary guides (20) has the shape of a pad of generally straight prismatic shape where the dimensions of the base the cylinder are substantially equal to those of the surface of the corresponding photovoltaic cell.

**8.** Photovoltaic device according to one of claims 4 to 7 **characterized in that** the one or each secondary guide has an index of refraction included between the index of refraction of the primary guide and the index of refraction of the surface of the corresponding photovoltaic cell.

**9.** Fabrication method of a photovoltaic device comprising:

- a plurality of photovoltaic cells (8), separated from each other;
- a support (6), the support (6) being a reflector having a reflecting surface (14) near which the cells (8) are laid out; and
- a light guide (10) in contact with said photovoltaic cells and comprising a primary guide (18) with a surface (22) that is proximal to the cells, where the proximal surface is oriented towards the cells and said reflecting surface,

wherein:

- the photovoltaic cells (8) are arranged near the support (6), and
- the light guide (10) is arranged in contact with the photovoltaic cells (8) by laying out, between the photovoltaic cells (8), areas (23) located between the primary guide (18) and the support (6) and which comprise a material (24) with an index of refraction less than that of the proximal surface (22), where said material is arranged in contact with said proximal surface;

- the primary guide (22) is arranged such that its proximal surface and the support (6) are separated by a distance (d) included between 1 $\mu$m and 20 $\mu$m and/or the primary guide is a fluorescent concentrator and the primary guide (22) is arranged such that its proximal surface is separated from the support (6) by a distance (d), where the distance (d) between the proximal surface and the support (6) is substantially equal to a multiple greater than or equal to two of a characteristic wavelength ($\lambda$) of the device and corresponding to a preferred wavelength of emission of the primary guide (18).

**10.** Fabrication method of a photovoltaic device according to claim 9, **characterized in that** one or more transparent secondary guides (20) are obtained which are each interposed between the primary guide (18) and one photovoltaic cell (8).

**11.** Fabrication method of a photovoltaic device according to claim 10, **characterized in that** each secondary guide (20) is formed by a deposit directly in contact with the corresponding photovoltaic cell (8).

**12.** Fabrication method of a photovoltaic device according to any one of claims 9 to 11, **characterized in that** all or part of the photovoltaic cells (8) are formed by deposition near the support (6) such that the corresponding photovoltaic cells project from the support and **in that** the primary guide (18) is deposited in contact with said projecting cells.

FIG. 1

FIG. 2

FIG. 3

FIG. 4

**EP 3 152 787 B1**

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- WO 2013183752 A